# EUROPEAN PATENT APPLICATION

(11) **EP 4 657 988 A1**
(43) Date of publication of application: **03.12.2025**
(21) Application number: 24747472.9
(22) Date of filing: 25.01.2024
(51) Int. Cl.: H05B 33/04, F21K 9/68, F21S 2/00, H05B 33/22, H01L 33/60, H01L 33/52, F21K 9/237, F21Y 115/10

(54) **LIGHTING MODULE AND LIGHTING DEVICE**

(30) Priority: 26.01.2023 KR 20230010264
(71) Applicant: LG INNOTEK CO. LTD, Gangseo-gu Seoul 07796 (KR)
(72) Inventor: CHOI, Hyun Ho, Seoul 07796 (KR); KIM, Jae Hyun, Seoul 07796 (KR)
(74) Representative: M. Zardi & Co S.A.
(86) International application number: PCT/KR2024/001235
(87) International publication number: WO 2024/158239

(57) **Abstract**

A lighting device disclosed in an embodiment of the invention may include a substrate; a light source disposed on the substrate; a resin layer sealing the light source; a reflective layer disposed between the substrate and the resin layer; a reflective portion bent from the reflective layer to face an emission surface of the light source; and a bonding portion disposed between the reflective portion and the substrate.

## Description

### [Technical Field]

An embodiment of the invention relates a lighting module and a lighting device.

### [Background Art]

Lighting applications include vehicle lights as well as backlights for displays and signs. Light emitting device, such as light emitting diode (LED), have advantages such as low power consumption, semi-permanent life, fast response speed, safety, and environmental friendliness compared to conventional light sources such as fluorescent lamps and incandescent lamps. These light emitting diodes are applied to various display devices, various lighting devices such as indoor or outdoor lights. A lamp employing a light emitting diode as a vehicle light source has been proposed. Compared with incandescent lamps, light emitting diodes are advantageous in that power consumption is small. However, since an emission angle of light emitted from the light emitting diode is small, when the light emitting diode is used as a vehicle lamp, there is a demand for increasing the light emitting area of the lamp using the light emitting diode. Since the light emitting diode is small, it may increase the design freedom of the lamp, and it is economical due to its semi-permanent life.

### [Disclosure]

### [Technical Problem]

An embodiment of the invention provides a lighting module and a lighting device which improves reflection efficiency by using a reflective layer inclined with light emitted from a light emitting device sealed in a resin layer. An embodiment of the invention provides a lighting module and a lighting device in which a portion of a reflective layer disposed between a resin layer and a substrate is bent at a predetermined angle using a bonding portion.

An embodiment of the invention provides a lighting module and a lighting device disposed between a substrate and a resin layer and having an inclined reflective layer that changes a path of light by facing at least one outer side surface of the light emitting device. An embodiment of the invention may provide a lighting module and a lighting device having a reflective layer bent toward an upper surface of the resin layer between a plurality of light emitting devices or on an emission side of each light emitting device. An embodiment of the invention may improve reliability of a lighting module and a lighting device, and may apply the module or the device to an electronic device.

### [Technical Solution]

A lighting device according to an embodiment of the invention may include a substrate; a light source disposed on the substrate; a resin layer sealing the light source; a reflective layer disposed between the substrate and the resin layer; a reflective portion bent from the reflective layer to face an emission surface of the light source; and a bonding portion disposed between the reflective portion and the substrate.

A lighting device according to an embodiment of the invention may include a substrate; a light source disposed on the substrate; a resin layer sealing the light source; a first reflective layer disposed between the substrate and the resin layer; a second reflective layer disposed on the resin layer and facing the first reflective layer; a reflective portion bent from the first reflective layer to face a side surface excluding an emission surface of the light source; and a bonding portion disposed between the reflective portion and the substrate.

According to an embodiment of the invention, the substrate may include a bonding pad to which the bonding portion is bonded. The bonding portion may be made of a solder material. An upper end of the reflective portion may be disposed higher than an upper surface of the light source.

According to an embodiment of the invention, the bonding portion may have a continuous or discontinuous loop shape. Each of the bonding portion and the bonding pad may be disposed at least one on at least one side of the light source. The bonding portion may be disposed in a circular or polygonal shape around the light source.

According to an embodiment of the invention, the end of the reflective portion may be exposed to the side surface of the resin layer. The reflective portion may include a reflective pattern disposed on an upper surface thereof.

According to an embodiment of the invention, the reflective portion may be bent toward the upper surface of the resin layer in a region adjacent to the first surface of the resin layer facing the emission surface of the light source. The lower line of the reflective portion may be a straight line or a curved shape along the side surface of the resin layer.

According to an embodiment of the invention, the light source may be a side-view type light-emitting device package that emits light toward the side surface of the resin layer. The light source may be a flip-chip type light-emitting device package that emits light on at least five sides. The reflective portion may extend from the reflective layer with a thickness equal to the thickness of the reflective layer.

### [Advantageous Effects]

According to an embodiment of the invention, light loss in a lighting device can be reduced and light extraction efficiency can be improved. According to an embodiment of the invention, by tilting or bending a portion of the reflective layer between the substrate and the resin layer, light loss can be reduced and bright spots and bright lines can be improved in the surface light distribution without additionally installing a separate structure. In addition, dark regions in the periphery of the lighting module can be reduced.

According to an embodiment of the invention, the reflective layer can be tilted or bent using a bonding portion bonded to a dummy pad of the substrate, so that light loss can be reduced without adding a process and structure. According to an embodiment of the invention, a lighting module and a lighting device having a uniform lighting image can be provided, and the reliability of an electronic device having the same can be improved.

### [Description of Drawings]

FIG. 1 is an example of a side cross-sectional view of a lighting device according to a first embodiment of the invention.
FIG. 2 is an example of the lighting device of FIG. 1 coupled to a housing.
FIG. 3 is another example of a bonding portion of the lighting device of FIG. 1.
FIG. 4 is another example of a lighting device of FIG. 2.
Figs. 5 and 6 are plan views showing the shape of a reflective portion of a reflective layer according to an embodiment of the invention.
FIG. 7 is an example of a side cross-sectional view of a lighting device according to a second embodiment of the invention.
FIGS. 8 (A)-(D) are drawings showing examples of joints disposed around a light emitting device of FIG. 7.
FIG. 9 is a perspective view of a lighting device according to a third embodiment of the invention.
FIG. 10 is a B-B side cross-sectional view of the lighting device of FIG. 9.
FIG. 11 is a C-C side cross-sectional view of the lighting device of FIG. 9.
FIG. 12 is a plan view showing a reflective portion of a reflective layer on the lighting device of FIG. 9.
FIG. 13 is a drawing showing an example of a plan view of a vehicle having the lighting device of the invention.
FIG. 14 is an example of a tail light of a vehicle to which the lighting device of FIG. 13 is applied.

### [Best Mode]

Hereinafter, preferred embodiment of the invention will be described in detail with reference to the accompanying drawings.

The technical spirit of the invention is not limited to some embodiments to be described, and may be implemented in various other forms, and one or more of the components may be selectively combined and substituted for use within the scope of the technical spirit of the invention. In addition, the terms (including technical and scientific terms) used in the embodiments of the invention, unless specifically defined and described explicitly, may be interpreted in a meaning that may be generally understood by those having ordinary skill in the art to which the invention pertains, and terms that are commonly used such as terms defined in a dictionary should be able to interpret their meanings in consideration of the contextual meaning of the relevant technology. Further, the terms used in the embodiments of the invention are for explaining the embodiments and are not intended to limit the invention. In this specification, the singular forms also may include plural forms unless otherwise specifically stated in a phrase, and in the case in which at least one (or one or more) of A and (and) B, C is stated, it may include one or more of all combinations that may be combined with A, B, and C. In describing the components of the embodiments of the invention, terms such as first, second, A, B, (a), and (b) may be used. Such terms are only for distinguishing the component from other component, and may not be determined by the term by the nature, sequence or procedure etc. of the corresponding constituent element. And when it is described that a component is "connected ", "coupled" or "joined" to another component, the description may include not only being directly connected, coupled or joined to the other component but also being "connected ", "coupled" or "joined" by another component between the component and the other component. In addition, in the case of being described as being formed or disposed "above (on)" or "below (under)" of each component, the description includes not only when two components are in direct contact with each other, but also when one or more other components are formed or disposed between the two components. In addition, when expressed as "above (on)" or "below (under)", it may refer to a downward direction as well as an upward direction with respect to one element.

The lighting device according to the invention may be applied to a variety of lamp devices that require lighting, such as vehicle lamps, home lighting devices, or industrial lighting devices. For example, when applied to vehicle lamps, it is applicable to headlamps, sidelights, side mirrors, fog lights, tail lamps, brake lights, daytime running lights, vehicle interior lights, door scars, rear combination lamps, backup lamps, etc. The lighting device of the invention may be applied to indoor and outdoor advertising devices, display devices, and various electric vehicle fields, and in addition, it may be applied to all lighting-related fields or advertisement-related fields that are currently developed and commercialized or that may be implemented according to future technological developments.

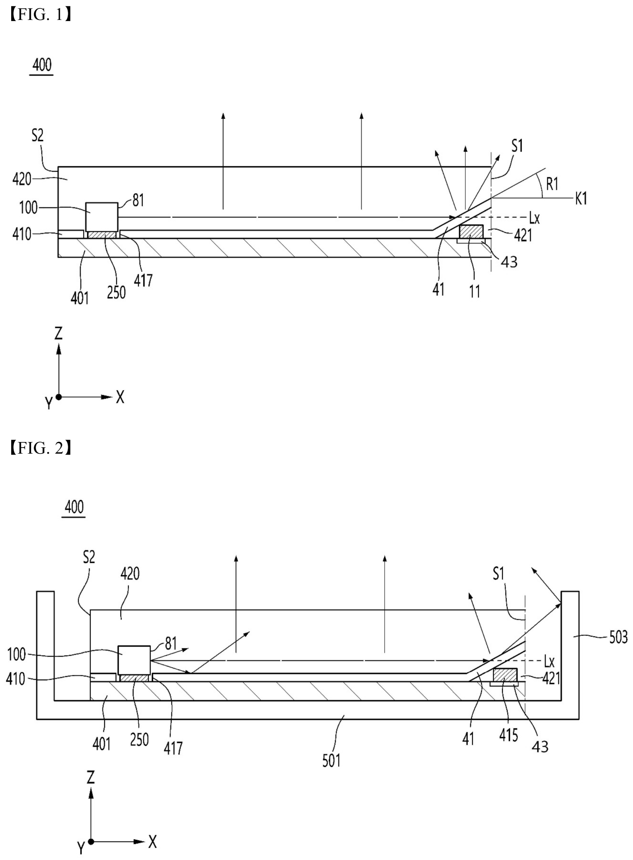

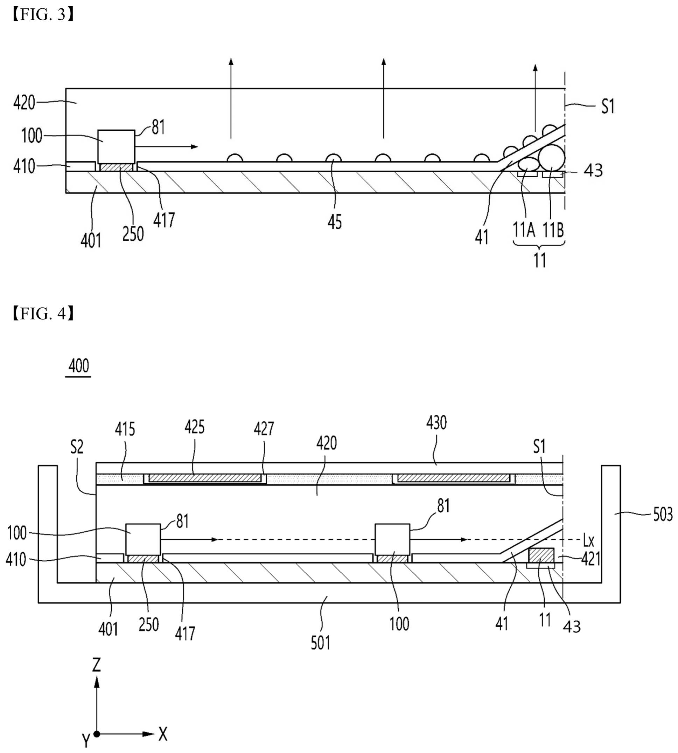

FIG. 1 is an example of a side cross-sectional view of a lighting device according to a first embodiment of the invention, FIG. 2 is an example of the lighting device of FIG. 1 coupled to a housing, FIG. 3 is another example of a bonding portion of the lighting device of FIG. 1, FIG. 4 is another example of the lighting device of FIG. 2, and FIGS. 5 and 6 are plan views showing the shape of an inclined portion of a reflective layer according to an embodiment of the invention.

Referring to FIGS. 1 to 6, a lighting device 400 according to an embodiment of the invention may include a substrate 401, a reflective layer 410, a light source 100, and a resin layer 420. The substrate 401 may include a printed circuit board (PCB). The substrate 401 may include, for example, at least one of a resin-based printed circuit board (PCB), a PCB having a metal core, a flexible material PCB, a ceramic material PCB, or an FR-4 substrate. When the substrate 401 is disposed as a metal core PCB with a metal layer disposed on the bottom, the heat dissipation efficiency of the light source 100 can be improved.

The substrate 401 may be electrically connected to the light source 100. The substrate 401 includes a wiring layer (not shown) on the upper side, and the wiring layer may be electrically connected to the light source 100. The light source 100 includes one or a plurality of light emitting devices, and the light emitting devices may be elements or packages having light-emitting diodes (LEDs).

When a plurality of light emitting devices are disposed on the substrate 401, the plurality of light emitting devices may be connected in series, in parallel, or in series-parallel by the wiring layer. The substrate 401 may function as a base member or a support member disposed under the light source 100 and the resin layer 420. Here, the light emitting devices of the light source 100 may be driven in groups or simultaneously. The upper surface of the substrate 401 may have an X-Y plane. The upper surface of the substrate 401 may be a flat plane or a curved surface. The thickness of the substrate 401 may be a height in the vertical direction or the Z direction. Here, in the X-Y plane, the X direction may be a first direction, and the Y direction may be a second direction. The Z direction may be a direction orthogonal to the first and second directions (X, Y). The plurality of first light sources 100 may be arranged at a constant pitch in the direction in which light is emitted from the substrate 401, but are not limited thereto. The substrate 401 may be provided in a linear or curved bar shape in the long direction. The substrate 401 may include a light-transmitting material through which light is transmitted through the upper surface and the lower surface. The light-transmitting material may include at least one of PET (Polyethylene terephthalate), PS (Polystyrene), and PI (Polyimide).

The substrate 401 may include, for example, an insulating layer or a reflective material layer protecting the circuit pattern on the upper side.

The light source 100 is disposed on the substrate 401 and emits light in the first direction (X). The light source 100 emits light with the highest intensity through the emission surface 81. The light source 100 may have an emission surface 81 through which light is emitted, and the emission surface 81 may be arranged, for example, in the third direction (Z) or in the vertical direction with respect to the horizontal upper surface of the substrate 401. The emission surface 81 may be a vertical plane, or may include a concave surface or a convex surface. The light source 100 may be bonded to a circuit pattern having pads disposed on the substrate 401 and a bonding member 250, and the bonding member 250 may be made of a conductive material and may be made of a solder material or a metal material. The light source may include a plurality of light sources 100, and the plurality of light sources 100 may be disposed in one or more columns and/or one or more rows.

The light source 100 may emit at least one of blue, red, green, ultraviolet (UV), and infrared, and the light source 100 may include an LED chip that emits at least one of white, blue, red, green, and infrared. The light source 100 may be a side view type light emitting device package whose bottom portion is electrically connected to the substrate 401. As another example, the light source 100 may be an LED chip or a top view package.

When the light source 100 is a side-view type light emitting device, the emission surface 81 of the light emitting device is disposed on one side of the light emitting device, and the other sides may be non-emission surfaces by a body made of a reflective material.

Some of the light emitted through the emission surface 81 of the light source 100 may proceed in a direction parallel to the upper surface of the substrate 401, may be reflected by the reflective layer 410, or may proceed toward the upper surface of the resin layer 420. The thickness of the light source 100 may be, for example, 3 mm or less, for example, in the range of 0.8 mm to 2 mm. The light source 100 may be embedded in the lower portion of the resin layer 420. The emission surface 81 and the side surfaces of the light source 100 may be in contact with the resin layer 420.

The reflective layer 410 may be a layer separately attached to the upper portion of the substrate 401. The reflective layer 410 may be disposed between the substrate 401 and the resin layer 420. The reflective layer 410 may be adhered to the upper surface of the substrate 401. The reflective layer 410 may have an area smaller than the upper surface area of the substrate 401. The reflective layer 410 may be spaced apart from the edge of the substrate 401, and the resin layer 420 may be attached to the upper edge of the substrate 401 in the spaced region. Accordingly, the edge portion of the reflective layer 410 may be prevented from being peeled off. The reflective layer 410 may include a hole 417 in which the lower portion of the light source 100 is disposed. The hole 417 of the reflective layer 410 may be disposed such that the upper surface of the substrate 401 is exposed and the lower portion of the light source 100 is bonded. The size of the hole 417 may be disposed to be the same as or larger than the size of the light source 100, but is not limited thereto.

The reflective layer 410 may be bonded between the resin layer 420 and the substrate 401. The reflective layer 410 may be formed to a thickness thinner than the thickness of the light source 100. The thickness of the reflective layer 410 may include a range of 0.23 mm ± 0.02 mm. The lower portion of the light source 100 may be penetrated through the hole 417 of the reflective layer 410, and the upper portion of the light source 100 may protrude beyond the upper surface of the reflective layer 410. The emission surface 81 of the light source 100 may be provided in a direction perpendicular to the upper surface of the reflective layer 410.

The reflective layer 410 may be provided as a film having a single-layer or multi-layer structure. The reflective layer 410 may include a metallic material or a non-metallic material. The metallic material may include a metal such as aluminum, silver, or gold. The non-metallic material may include a plastic material or a resin material. The resin material may include a metal oxide such as TiO₂, Al₂O₃, or SiO₂ added to silicone or epoxy. The reflective layer 410 may be implemented as a single-layer or multi-layer, and the light reflection efficiency may be improved by this layer structure. The reflective layer 410 according to an embodiment of the invention may increase the amount of light by reflecting incident light so that the light is emitted with a uniform distribution. The reflective layer 410 may include a reflective pattern 45 (See FIG. 3) protruding on an upper surface thereof. The reflective pattern 45 may reflect the light that is being transmitted, and can improve the distribution of the surface light extracted through the surface of the resin layer 420. The density of the reflective pattern 45 may be distributed with a uniform interval, or may be distributed with a higher density or a narrower interval as it gets farther away from the emission surface 81 of the light source 100.

The resin layer 420 may be disposed on the substrate 401. The resin layer 420 may be disposed on the reflective layer 410. The resin layer 420 may be disposed on the entire upper surface or a portion of the upper surface of the reflective layer 410. The lower surface area of the resin layer 420 may be equal to or larger than the upper surface area of the reflective layer 410. The resin layer 420 may be formed of a transparent material and can guide or diffuse light. The resin layer 420 may be formed of a resin-based material, and may include a resin material such as silicone or epoxy, or a UV-curable resin material. Such a resin material may be used instead of a light guide plate, and has the effect of conveniently controlling the refractive index and thickness.

In addition, the resin layer 420 uses the oligomer disclosed as a main material, and mixes IBOA, a diluting monomer, and GMA to control hardness, heat resistance, and transmittance, and suppress adhesion and oxidation prevention. The resin layer 420 may include a photo initiator and a light stabilizer to control curing and suppress discoloration. Since the resin layer 420 is provided as a layer that guides light with resin, it may be provided with a thinner thickness than in the case of glass, and may be provided as a flexible plate. The resin layer 420 may emit point light emitted from a light source 100 in the form of a line light source or area light.

The resin layer 420 may include a diffusion agent such as a bead (not shown), and the bead may diffuse and reflect incident light to increase the amount of light. The bead may be disposed in a range of 0.01 to 0.3% relative to the weight of the resin layer 420. The bead may be composed of any one selected from among silicon, silica, glass bubble, PMMA (Polymethyl methacrylate), urethane, Zn, Zr, Al₂O₃, and acryl, and the particle size of the bead may be in a range of about 1 µm to about 20 µm, but is not limited thereto.

The resin layer 420 may include a phosphor (not shown) therein. The phosphor may convert the wavelength of the light of the light source 100, and may convert it into at least one of red, green, or blue, for example. As another example, when the phosphor is disposed in a region adjacent to the light source 100, i.e., within the resin layer 420, damage may occur due to heat, so a separate wavelength conversion layer (not shown) may be further disposed on the upper surface of the resin layer 420. The wavelength conversion layer may include a phosphor therein, or may include a phosphor and ink particles. The ink particles may include red or yellow ink particles.

Since the resin layer 420 is disposed on the light source 100, it may seal the light source 100 and protect the surface of the light source 100, and reduce the loss of light emitted from the light source 100. The light source 100 may be embedded in the lower portion of the resin layer 420. The resin layer 420 may contact the surface of the light source 100 and may contact the emission surface 81 of the light source 100. A portion of the resin layer 420 may be disposed in the hole 417 of the reflective layer 410. A portion of the resin layer 420 may be in contact with the upper surface of the substrate 401 through the hole 417 of the reflective layer 410. Accordingly, a portion of the resin layer 420 may be in contact with the substrate 401, thereby fixing the reflective layer 410 between the resin layer 420 and the substrate 401.

The thickness of the resin layer 420 may be 1.8 mm or more, for example, in a range of 1.8 mm to 2.5 mm. If the thickness of the resin layer 420 is thicker than the above range, the brightness may be reduced and it may be difficult to provide a flexible module due to the increase in module thickness. If the thickness of the resin layer 420 is smaller than the above range, it is difficult to provide surface light with uniform brightness. The resin layer 420 may be provided in a size that covers a plurality of light sources 100. The resin layer 420 may be separated into sizes that cover each of the plurality of light sources 100. Among the side surfaces of the resin layer 420, a first side S1 facing the emission side 81 of the light source 100 and a second side S2 facing the back surface of the light source 100, that is, the opposite side of the emission side 81 may be included. The first side S1 and the second side S2 may be opposite sides.

The light source 100 may emit light toward the first side S1. The light emitted by the light source 100 may be guided through the resin layer 420, reflected by the reflective layer 410, and then emitted through the surface, i.e., the upper portion, of the resin layer 420. The resin layer 420 may provide uniformly distributed surface light.

In addition, the resin layer 420 may include an optical member 430 as in FIG. 4 for uniform light distribution on the upper portion. The optical member 430 may include a single layer or multiple layers and may include a diffusion material. The diffusion material may include at least one of polyester (PET), PMMA (Poly Methyl Methacrylate), or PC (Poly Carbonate).

Some of the light emitted from the light source 100 may travel toward the side surfaces of the resin layer 420. In this case, light loss may occur through the sides of the resin layer 420, and for uniform light distribution, a number of light sources 100 may be increased, the interval between the light sources 100 may be made narrower, the pattern shape or density of the reflective pattern 45 may be increased, or a light emitting device having high output may be required.

In an embodiment of the invention, the reflective layer 410 may include a reflective portion 41. The reflective portion 41 may be disposed in a region adjacent to the first surface S1 of the resin layer 420 facing the emission surface 81 of the light source 100. The reflective portion 41 may protrude higher than the upper surface of the reflective layer 410. The reflective portion 41 may be bent from a portion of the reflective layer 410 toward the upper surface of the resin layer 420. Since the reflective portion 41 is formed by bending and extending a portion of the reflective layer 410, a thickness of the reflective portion 41 and a thickness of the reflective layer 410 may be the same.

At least a portion of the reflective portion 41 may face the emission surface 81 of the light source 100. The reflective portion 41 may be disposed between the emission surface 81 and the first surface S1. Accordingly, the reflective portion 41 may reflect light emitted through the emission surface 81 of the light source 100 toward the upper surface of the resin layer 420. The upper end of the reflective portion 41 may be disposed higher than the optical axis (Lx) of the light source 100. The upper end of the reflective portion 41 may be disposed higher than a straight line that is horizontal to the upper surface of the light source 100. Accordingly, light in the direction of the optical axis with the highest luminous intensity from the light source 100 may be reflected to the reflective portion 41, and light loss leaking through the first surface S1 of the resin layer 420 may be reduced. The upper end of the reflective portion 41 may be disposed higher than the optical axis (Lx) and lower than the upper surface of the resin layer 420. The upper height of the reflective portion 41 may be 0.15 mm or more, for example, in the range of 0.15 mm to 2.2 mm from the surface of the reflective layer 410.

The reflective portion 41 has a straight line connecting the reflective layer 410 and the bent point of the reflective portion 41 to the upper end of the reflective portion 41 at an angle R1 inclined with respect to the straight line K1 horizontal to the upper end of the reflective portion 41, and the angle R1 may be less than 90 degrees, for example, in the range of 10 degrees to 80 degrees or in the range of 15 degrees to 60 degrees. If the angle R1 of the reflective portion 41 is smaller than the above range, the effect of suppressing light loss may be reduced or a dark region may occur on the first surface S1, and if it is larger than the above range, a hot spot may occur around the first surface S1 of the resin layer 420.

The end of the reflective portion 41 may or may not be exposed to the first surface S1 of the resin layer 420. If the end of the reflective portion 41 is exposed to the first surface S1 of the resin layer 420, the reflective portion 41 may be disposed at an angle, the resin layer 420 may be molded, and then the end of the reflective portion 41 may be supported by exposing it to the outside of the side surface of the resin layer 420, and then a cutting process may be performed. In this case, the problem of the angle of inclination of the reflective portion 41 being distorted in the molding process of the resin layer 420 may be prevented. If the end of the reflective portion 41 is not exposed to the first surface S1 of the resin layer 420, the resin layer 420 wraps around the outside of the reflective portion 41, and thus the end of the reflective portion 41 may be protected.

The bonding portion 11 may be disposed between the substrate 401 and the reflective portion 41. The bonding portion 11 is a material that is bonded on the pad of the substrate 401, and may be, for example, a conductive material, a solder material, or a metal material. That is, a bonding pad 43, i.e., a dummy pad, may be exposed in the region of the substrate 401 where the bonding portion 11 is formed, and the bonding portion 11 may be formed on the dummy pad. The bonding pad 43 may be a pad that is not electrically connected to the light source 100.

An area of the bonding pad 43 may be the same as or different from an area of the bonding portion 11, and may correspond to an area of the bonding portion 11. A shape of the upper surface of the bonding pad 43 may correspond to a shape of the lower surface of the bonding portion 11. In addition, when the bonding pads 43 are plural and the bonding portions 11 are plural, the number of the bonding pads 43 and the bonding portions 11 may be the same. The bonding portion 11 may have a polygonal or hemispherical cross-section. The bonding portion 11 may have a solder ball shape, as shown in FIG. 3. In addition, the bonding portion 11 may include a plurality of bonding portions 11A and 11B for the inclination or height of the reflective portion 41, and the plurality of bonding portions 11A and 11B may have different heights or thicknesses and support the lower surface of the reflective portion 41. The plurality of bonding portions 11A and 11B may be disposed in the direction of the optical axis, and may have a greater height or thickness as they approach the first surface S1. Accordingly, the height from the bottom to the top of the reflective portion 41 may be provided at a constant angle R1.

The thickness of the bonding portion 11 may be thicker than the thickness of the reflective layer 410. The center thickness or minimum thickness of the bonding portion 11 may be more than 1 to 5 times the thickness of the reflective layer 410, and may be, for example, in the range of 1.5 to 5 times or 2 to 4 times. If the thickness of the bonding portion 11 is smaller than the above range, a problem of the upper end of the reflective portion 41 being bent may occur, and if it is larger than the above range, a concave groove or an irregular curved surface may occur at the lower end of the reflective portion 41, and such a structure may reduce the uniformity of the light distribution.

The maximum thickness of the bonding portion 11 may be at least 1/2 of the vertical distance between the upper end of the reflective portion 41 of the reflective layer and the upper surface of the substrate 401. That is, by supporting the lower end of the 1/2 point between the lower end and the upper end of the reflective portion 41 at the position of the bonding portion 11, the problem of the lower end of the reflective portion 41 being concave or the upper end being bent may be reduced.

In an embodiment of the invention, the bonding portion 11 is disposed at the lower portion of the reflective layer 410, and the reflective portion 41 may be disposed to be bent toward the upper surface of the resin layer 420 by the bonding portion 11 and face the emission surface 81 of the light source 100. Accordingly, the amount of light emitted through the emission surface 81 of the light source 100 leaking through the first surface S1 of the resin layer 420 may be reduced, and the light uniformity around the first surface S1 of the resin layer 420 may be improved.

In addition, the first region 421 between the reflective portion 41 and the substrate 401 may be filled with the resin layer 420, or may be an adhesive or air region. When the resin layer 420 is filled with the first region 421, an opening is formed in the reflective portion 41, and a portion of the molded resin layer 420 may be filled.

FIG. 2 is a structure in which a housing is disposed on the outside of the lighting device of FIG. 1.

Referring to FIG. 2, the housing 501 supports the bottom of the substrate 401, and the outer side portion 503 may be disposed higher than the upper surface of the resin layer 420 on both sides of the resin layer 420. The side portion 503 of the housing 501 may reflect light leaking through the upper portion of the first surface S1 of the reflective portion 41 or the resin layer 420.

As shown in FIG. 3, a reflective pattern 45 is formed on the upper surface of the reflective layer 410, and the reflective pattern 45 may be formed on the reflective portion 41. The reflective pattern formed on the reflective portion 41 may be disposed with a smaller size or higher density than the reflective pattern adjacent to the light source 100.

As shown in FIG. 4, the lighting device 400 has an optical member 430 disposed on an upper portion of the resin layer 420. The optical member 430 may be a single-layer or multi-layer diffusion plate. A light blocking member 425 is disposed between the optical member 430 and the resin layer 420. The light blocking member 425 is disposed on upper portion of a light source 100 from which light is emitted, and may suppress hot spots by blocking or reflecting incident light. The light blocking member 425 may overlap with the light source 100 in a vertical direction. The light blocking member 425 may be formed as a single-layer or multi-layer, and may include a reflector. The area of the light shielding portion 425 may be disposed to be larger than the upper surface area of the light source 100, or may be 1.5 times or more than the upper surface area of the light source 100.

The optical member 430 may include at least one or two or more of a dispersant such as a bead, a phosphor, and an ink particle. The phosphor may include, for example, at least one of a red phosphor, an amber phosphor, a yellow phosphor, a green phosphor, or a white phosphor. The ink particle may include at least one of a metallic ink, a UV ink, or a curing ink. The size of the ink particle may be smaller than the size of the phosphor. The surface color of the ink particle may be any one of green, red, yellow, and blue. The ink types may be selectively applied from among PVC (Poly vinyl chloride) ink, PC (Polycarbonate) ink, ABS (acrylonitrile butadiene styrene copolymer) ink, UV resin ink, epoxy ink, silicone ink, PP (polypropylene) ink, water-based ink, plastic ink, PMMA (poly methyl methacrylate) ink, and PS (polystyrene) ink. The ink particles may include at least one of metal ink, UV ink, or curing ink.

An adhesive layer 415 is disposed between the optical member 430 and the resin layer 420, and the adhesive layer 415 bonds between the optical member 430 and the resin layer 420. The light blocking portion 425 may be separated by an air gap 427 inside the adhesive layer 415. The lower surface of the light blocking portion 425 may not be in contact with the upper surface of the resin layer 420. The thickness of the light blocking portion 425 may be thinner than the thickness of the adhesive layer 415, so that a region between the lower surface of the light blocking portion 425 and the upper surface of the resin layer 420 may be a portion of the air gap 427, i.e., an enclosed space. This enclosed space may improve the light diffusion efficiency.

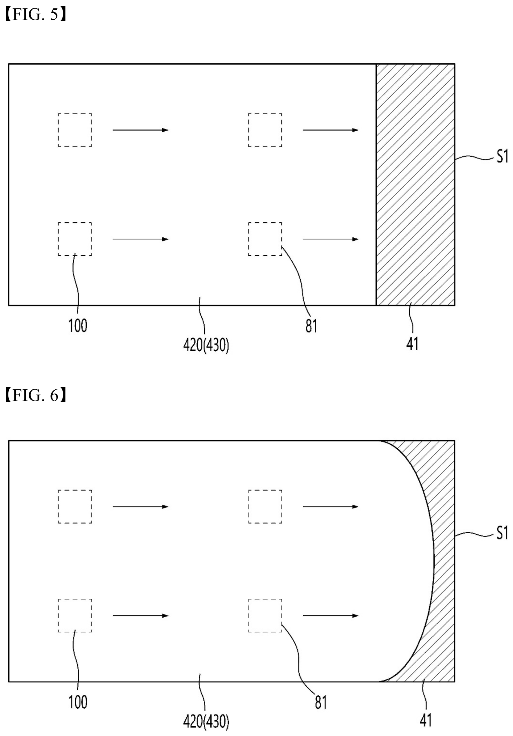

As shown in FIG. 5, the reflective portion 41 of the reflective layer 410 is disposed obliquely in a region facing the emission surface 81 of the light source 100, and the lower line of the reflective portion 41 may be disposed in a parallel straight line along the first surface S1 of the resin layer 420. The distance between the lower line of the reflective portion 41 and the first surface S1 may be the same.

As shown in FIG. 6, the reflective portion 41 of the reflective layer 410 is disposed obliquely in a region facing the emission surface 81 of the light source 100, and the lower line of the reflective portion 41 may be disposed not parallel to the first surface S1 of the resin layer 420. The distance between the lower line of the reflective portion 41 and the first surface S1 may be smaller in a region where the light sources 100 are disposed, and may be larger on the outside of the outermost light source 100. That is, the lower line of the reflective portion 41 is formed as a curved line having a narrow center width and a wide outer width, so that the distance from the emission surface 81 of the light source 100 may be maintained within a predetermined range. Accordingly, the distribution of light reflected by the reflective portion 41 may be uniform at the center and outside of the reflective portion 41.

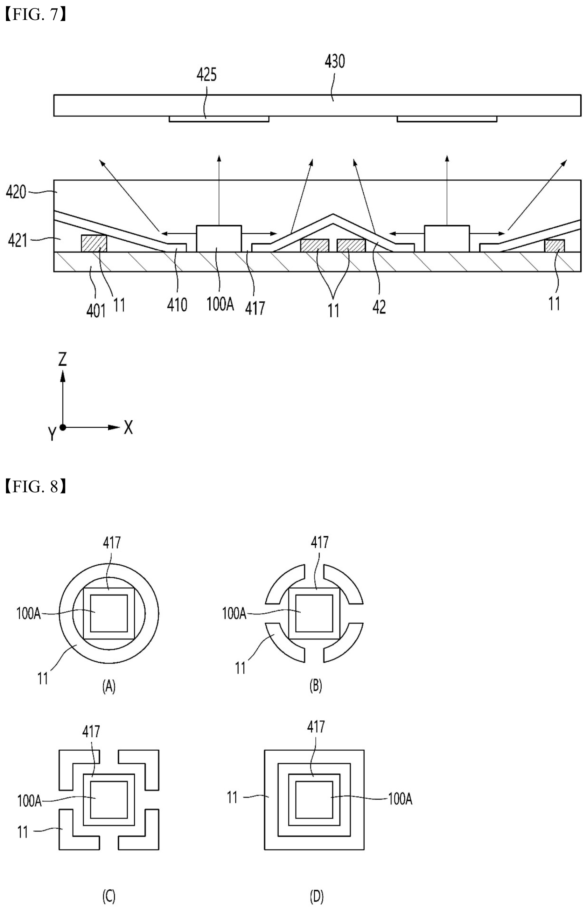

FIGS. 7 and 8 are lighting devices according to the second embodiment. In the description of the second embodiment, the overlapping part with the first embodiment may include the description of the first embodiment.

Referring to FIGS. 7 and 8, the light source 100A may include a light emitting device that emits light on at least five sides. The light emitting device may be a flip-chip type light emitting device (LED) package. Here, at least four sides of the light source 100A may be defined as the emission surface disclosed above. The reflective portion 41 of the reflective layer 410 is disposed around the periphery of the light source 100A, and may be disposed around each side of the light source 100A, for example. The reflective portion 41 of the above-described reflective layer 410 is spaced apart from each side of the light source 100A by the same distance, so as to reflect light with a uniform distribution. The reflective portion 41 is provided with an inclined structure on both sides or all sides of the light source 100A, so as to reflect light emitted through the sides of the light source 100A to the upper surface of the resin layer. The end of the reflective portion 41, which is the outer end of the reflective layer 410, may or may not be exposed to the sides of the resin layer 420.

The bonding portion 11 may be spaced apart from each side of the light source 100A by a certain distance. As shown in (A)(B)(C)(D) of FIG. 8, the bonding portion 11 may be disposed in a continuous loop shape or in a discontinuous loop shape. The bonding portion 11 may be circular or polygonal. The bonding portion 11 may be disposed in a region spaced apart from the hole in which the light source is disposed. The bonding portion 11 may be disposed on a bonding pad at the lower portion and may support the reflective portion 41. That is, each of the bonding portion 11 and the bonding pad may be disposed at least one on at least one side of the light source 100.

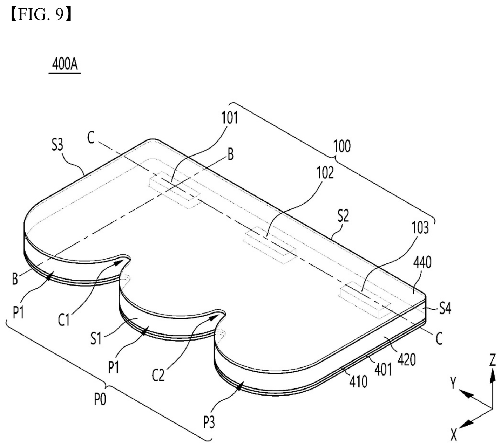

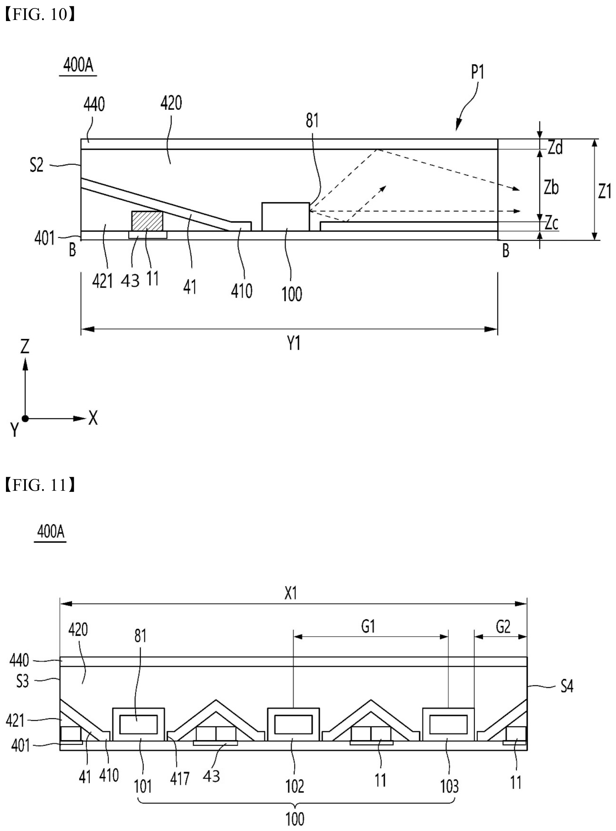

FIGS. 9 to 12 are lighting devices according to the third embodiment.

Referring to FIGS. 9 to 12, the lighting device 400A includes one or more light sources 100, and irradiates light emitted from the light source 100 as a line-shaped surface light source. The lighting module 400A may include a first surface S1 facing the light source 100, a second surface S2 opposite the front surface S1, and a plurality of third and fourth surfaces S3 and S4 extending in a second direction from both ends of the first surface S1 and the second surface S2. The first to fourth surfaces S1, S2, S3, and S4 are respective side surfaces of the resin layer 420.

In the lighting device 400A, a plurality of light sources 100 may be disposed in one direction. The plurality of light sources 100 may be arranged in one row, or as another example, may be arranged in two rows. The plurality of light sources 100 arranged in one direction may face the first surface S1, i.e., the front surface. Each of the emission surfaces 81 of the plurality of light sources 100 may face the first surface S1. Light emitted from the light sources 100 is emitted through the first surface S1, and some of the light may be directed toward the other side. With respect to the light source 100, a distance (D2) between the light source 100 and the first surface S1 and a distance (D3) between the light source 100 and the second surface S2 may be different from each other. The distance (D3) between the light source 100 and the second surface S2 may be 2 mm or more, and may be in a range of, for example, 2 mm to 20 mm. If the distance (D3) between the light source 100 and the second surface S2 is smaller than the above range, a region where moisture may penetrate or a circuit pattern may be formed may become smaller, and if it is larger than the above range, the size of the lighting device 400A may become larger.

The lighting device 400A may include a plurality of convex portions P1, P2, and P3 corresponding to each of the light sources 100 and a concave portion C1 and C2 between the plurality of convex portions P1, P2, and P3. Each of the convex portions P1, P2, and P3 corresponds to the center of each of the light sources 100, and the distance from the light source 100 may increase as the area corresponds to the center of each of the light sources 100. Each of the convex portions P1, P2, and P3 may protrude in the direction of the first surface S1 with respect to the light emitting device 101, 102, and 103, and the concave portions C1 and C2 may be formed to be concave in the direction of the second surface S2 with respect to the first surface S1. The convex portions P1, P2, and P3 may include convex curved surfaces. The concave portions C1 and C2 may include concave curved surfaces. The convex portions P1, P2, and P3 may have a first curvature, and the second concave portions C1 and C2 may have a second curvature having a radius smaller than the radius of the first curvature. The first surface S1 to the fourth surface S4 of the resin layer 420 may have the same thickness or the same height.

The lighting device 400A includes a substrate 401 at a lower portion of the resin layer 420, a first reflective layer 410 between the substrate 401 and the resin layer 420, and a second reflective layer 440 the resin layer 420. The resin layer 420 may be disposed to surround a plurality of light sources 100. Since the substrate 401 is provided with a thin thickness, a flexible lighting device may be provided. The first reflective layer 410 may be the same layer as the reflective layer of the first and second embodiments. The convex portions P1, P2, and P3 may include a first convex portion P1 corresponding to the first light emitting device 101, a second convex portion P2 corresponding to the second light emitting device 102, and a third convex portion P3 corresponding to the third light emitting device 103. The concave portions C1 and C2 may include a first concave portion C1 disposed between the first and second convex portions P1 and P2, and a second concave portion C2 disposed between the second and third convex portions P2 and P3.

Each of the convex portions P1, P2, an P3 may diffuse light emitted from the emission surface 81 of the light emitting device 101, 102, and 103. To this end, the first to third convex portions P1, P2, and P3 can overlap horizontally with the emission surface 81 of each of the first to third light emitting devices 101, 102, and 103.

The maximum width W1 of the convex portions P1, P2, and P3 is a distance between the adjacent concave portions C1 and C2, and may be equal to or smaller than the pitch G1 of the light sources 100. When the maximum width W1 of the convex portions P1, P2, and P3 is greater than the pitch G1 between the light sources 100, two or more light emitting devices may be disposed in the area of the convex portions P1, P2, and P3 and the light intensity may be increased. When the maximum width W1 of the convex portions P1, P2, and P3 is smaller than the pitch G1 between the light sources 100, the size of the convex portions P1, P2, and P3 is small, so that a uniform distribution of light may be provided, but the light intensity may be reduced. Here, the distance between the outermost light emitting device 103 and the outer side surface S4 of the resin layer 420 may be smaller than the pitch G1.

The first concave portion C1 may overlap horizontally with the area between the first and second light emitting devices 101 and 102, and the second concave portion C2 may overlap horizontally with the region between the second and third light emitting devices 102 and 103. The first and second concave portions C1 and C2 may transmit or reflect some of the incident light. The first and second concave portions C1 and C2 may suppress the occurrence of dark regions in the area between the light emitting devices 101, 102, and 103.

The first reflective layer 410 may be disposed between the resin layer 420 and the substrate 401. The resin layer 420 may cover the light source 100. The resin layer 420 may be in contact with the upper surface and side surfaces of the light source 100. The resin layer 420 may be in contact with the upper surface of the first reflective layer 410. A portion of the resin layer 420 may be in contact with the substrate 401 through the first reflective layer 410. The resin layer 420 may be in contact with the emission surface 81 of the light source 100.

The resin layer 420 may be disposed between the first and second reflective layers (410, 440). The first and second reflective layers 410 and 440 may have the same area and may be disposed to face each other on the lower surface and the upper surface of the resin layer 420. Accordingly, the resin layer 420 can diffuse and guide the light emitted from the light source 100 and the light reflected by the first and second reflective layers 410 and 440 in the lateral direction. The resin layer 420 may be formed with a thickness (Zb) thicker than the thickness of the light source 100. Accordingly, the resin layer 420 may protect the upper portion of the light source 100 and prevent moisture penetration.

The lighting device 400A has a long length Y1 in one direction and may be larger than the width X1 between the first and second surfaces S1 and S2. The thickness (Zb) of the resin layer 420 is the distance between the first and second reflective layers 410 and 440, and the distance (e.g., Zb) between the first and second reflective layers 410 and 440 may be smaller than the distance between the first surface S1 and the second surface S2. By arranging the distance between the first and second reflective layers 410 and 440 to be smaller than the width X1 or the minimum width of the lighting device 400A, a line-shaped surface light source may be provided, and brightness may be improved and hot spots may be prevented. The thickness (Zb) of the resin layer 420 may be twice or less than the thickness of the light source 100, and for example, may be more than 1 time and less than 2 times. The thickness (Zb) of the resin layer 420 may be, for example, in the range of 1.5 mm to 1.9 mm or in the range of 1.6 mm to 1.8 mm. The thickness (Zb) of the resin layer 420 may be 0.8 times or less than the thickness (Z1) of the lighting device 400A. Accordingly, the reduction in light efficiency in the lighting device 400A may be prevented and the ductility characteristics may be enhanced. The resin layer 420 may include a phosphor. The phosphor may include at least one of a yellow phosphor, a green phosphor, a blue phosphor, and a red phosphor.

The region where the convex portions P1, P2, and P3 are formed in the resin layer 420 may be provided as a lens portion. The lens portion of the resin layer 420 is a lens having a convex curve, and may include a hemispherical shape when viewed from the top. The lens section can refract light incident on an area outside the optical axis with an exit angle greater than the incident angle.

The first reflective layer 410 may reflect light emitted from the light source 100. The first reflective layer 410 may be formed on the upper surface of the substrate 401. The first reflective layer 410 may be bonded to the upper surface of the substrate 401 with an adhesive. The first reflective layer 410 has a plurality of holes 417 in a region corresponding to the lower surface of the light source 100, and the light source 100 may be connected to the substrate 401 through the holes 417. The first reflective layer 410 may be made of a white resin material or a plastic material. The first reflective layer 410 may be made of a white resin material or may include a polyester (PET) material. The first reflective layer 410 may include at least one of a low-reflective film, a high-reflective film, a diffuse reflective film, or a regular reflective film. The first reflective layer 410 may be provided as, for example, a regular reflective film for reflecting incident light to the first surface S1.

The thickness (Zc) of the first reflective layer 410 may be smaller than the thickness of the substrate 401. The thickness (Zc) of the first reflective layer 410 may be disposed to be 0.5 times or more the thickness of the substrate 401, thereby reducing the transmission loss of incident light. The thickness (Zc) of the first reflective layer 410 may be in the range of 0.2 mm to 0.4 mm. If it is smaller than the range, light transmission loss may occur, and if it is thicker than the range, the thickness (Z1) of the lighting device 400A may increase.

The second reflective layer 440 may be disposed on the resin layer 420. The second reflective layer 440 may be adhered to the upper surface of the resin layer 420. The second reflective layer 440 may be disposed on an area of the entire upper surface of the resin layer 420 to reduce light loss. The second reflective layer 440 may be made of the same material as the first reflective layer 410. The second reflective layer 440 may have a material having a higher light reflectivity or a thicker thickness than the material of the first reflective layer 410 in order to reflect light and reduce light transmission loss. The thickness (Zd) of the second reflective layer 440 may be the same as or thicker than the thickness (Zc) of the first reflective layer 410, and may have a material having a reflectivity that is the same as or higher than the material of the first reflective layer 410. The thickness (Zd) of the second reflective layer 440 may be smaller than the thickness of the substrate 401.

The first reflective layer 410 includes a reflective portion 41, and the reflective portion 41 may be disposed on both sides and the rear of each light emitting device 101, 102, and 103 of the light source 100. The reflective portion 41 faces both sides and the back of each light emitting device 101, 102, and 103 of the light source 100, and may not face the emission surface 81 of each light emitting device 101, 102, and 103. As another example, the reflective portion 41 may be respectively disposed on at least one or both of the lower portion of the convex portion P1, P2, and P3 of the resin layer 420 or the lower portion of the concave portion C1 and C2. As another example, the second reflective layer 420 may respectively be disposed on at least one or both of the lower portion of the convex portion P1, P2, and P3 of the resin layer 420 or the lower portion of the concave portion C1 and C2.

The first reflective layer 410 includes a reflective portion 41, and the reflective portion 41 may be disposed on both sides and the rear side of each light emitting device 101, 102, and 103 of the light source 100. The reflective portion 41 faces both sides and the rear side of each light emitting device 101, 102, and 103 of the light source 100, and may not face the emission surface 81 of each light emitting device 101, 102, and 103. As another example, the reflective portion 41 may be disposed on at least one or both of the lower portion of the convex portion (P1, P2, P3) of the resin layer 420 or the lower portion of the concave portion (C1, C2). As another example, the second reflective layer 420 may include a reflective portion disposed on at least one or both of the lower portions of the convex portions P1, P2, and P3 of the resin layer 420 or the lower portions of the concave portions C1 and C2.

The reflective portion 41 of the first reflective layer 410 may face a region other than the emission surface 81 of each of the light emitting devices 101, 102, and 103. Accordingly, light leaking through the second to fourth surfaces S2, S3, and S4 of each of the light emitting devices 101, 102, and 103 may be reflected. The inclination angle of the reflective portion 41 may be higher than the inclination angle of the first embodiment, and may be, for example, 20 degrees or more, for example, 30 degrees to 90 degrees. For example, based on each of the light emitting devices 101, 102, and 103, the first inclination angle of the reflective portion 41 adjacent to the second surface S2 may be the highest, and the second inclination angle of the reflective portion 41 adjacent to the third and fourth surfaces S3 and S4 may be smaller than the first inclination angle. That is, since light is extracted to the first surface S1 of the resin layer 420, the reflective portion 41 may be disposed to incline at a higher angle the farther away it is from the first surface S1. In addition, the reflective pattern 45 (See FIG. 3) disclosed may be disposed on the upper surface of the reflective portion 41. A bonding portion 11 may be disposed in the area between the reflective portion 41 and the substrate 401, and the bonding portion 11 may be bonded on the bonding pad 43. The bonding portion 11 is disposed in an area spaced apart from both sides and the rear of each light emitting device 101, 102, and 103 and supports the lower portion of the reflective portion 41. Since the material of the bonding portion 11 has higher rigidity than the material of the reflective portion 41, the problem of the reflective portion 41 being sagging due to the bonding portion 11 may be prevented. The bonding pad 43 and the bonding portion 11 may be formed continuously or discontinuously along the outer side excluding the emission side area of each of the light emitting devices 101, 102, and 103.

The upper end of the reflective portion 41 may be disposed higher than the upper surface of each of the light emitting devices 101, 102, and 103, and accordingly, the light reflective efficiency by the reflective portion 41 may be improved. In an embodiment of the invention, at least one or both of the first and second reflective layers 410 and 420 may include an inclined reflective portion or a bent reflective portion by the bonding portions disclosed above.

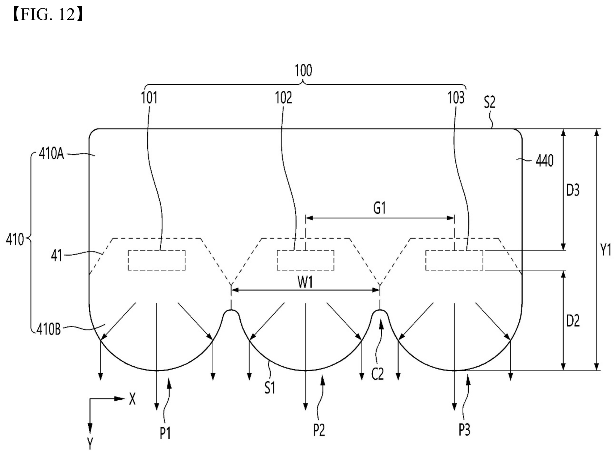

As shown in FIG. 12, the lower line of the reflective portion 41 may be disposed in a form that surrounds both sides and the rear of each light emitting device. Accordingly, the reflective layer 410 may include a flat region 410B in the forward direction and an inclined region 410A in the rear.

The laminated structure of the substrate 401, the first reflective layer 410, the resin layer 420, and the second reflective layer 440 may include the convex portions P1, P2, and P3 and the concave portions C1 and C2. The convex portions P1, P2, and P3 may have a flat shape on the upper and lower surfaces and may include a curved or hemispherical shape in the first direction. The concave portion C1 and C2 may include the concave curved surface in a direction of the rear surface S2. The convex curved surface and the concave curved surface in the resin layer 420 may be processed as a haze surface, thereby diffusing light. The haze surface may be processed as a rougher surface than the inner surface of the resin layer 420, thereby diffusing the emitted light. As another example, the reflective portion may be implemented by a second reflective layer 440.

The lighting device 400A according to the embodiment of the invention may provide a line-shaped surface light source having a thickness (Z1) and having flexibility. The thickness (Z1) of the lighting device 400A may be 3 mm or less. That is, the lighting device 400A may be provided as a line-shaped surface light source having a thickness of 3 mm or less.

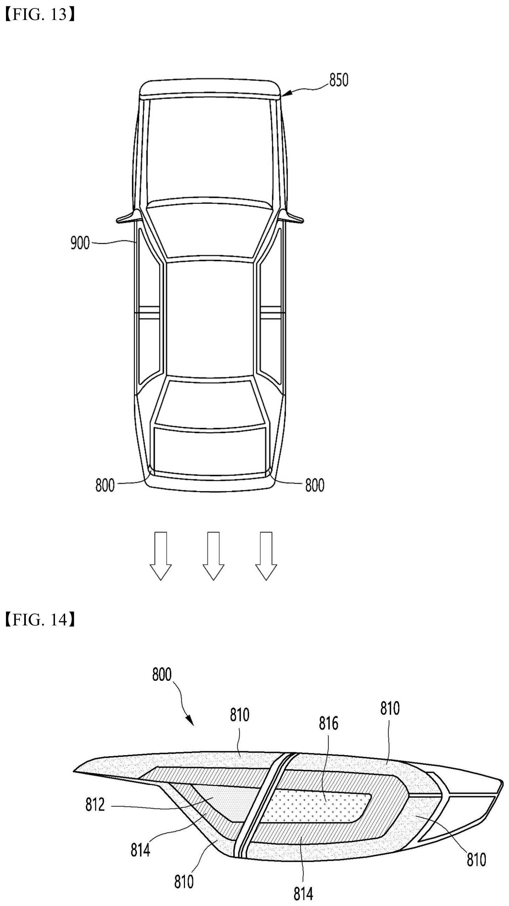

FIG. 13 is a plan view of a vehicle to which a lighting device according to an embodiment is applied, and FIG. 14 is a drawing showing an example of a tail light of the vehicle of FIG. 13.

Referring to FIG. 13 and FIG. 14, a front lamp 850 in a moving body or vehicle 900 may include one or more lighting modules, and the driving timing of these lighting modules may be individually controlled to provide not only a function as a conventional headlight, but also additional functions such as a welcome light or a celebration effect when a driver opens a vehicle door. The lamp may be applied to a daytime running light, a high beam, a low beam, a fog light, or a turn signal light.

In a vehicle 900, a tail light 800 may be disposed as a plurality of lamp units 810, 812, 814, and 816 supported by a housing 801. For example, the lamp units 810, 812, 814, and 816 may include a first lamp unit 810 disposed on the outside, a second lamp unit 814 disposed on the inner periphery of the first lamp unit 810, and third and fourth lamp units 814 and 816 disposed on the inside of the second lamp unit 814, respectively. The first to fourth lamp units 810, 812, 814, and 816 may selectively apply the lighting device disclosed in the embodiment, and a red lens cover or a white lens cover may be disposed on the outside of the lighting device for the lighting characteristics of the lamp unit 810, 812, 814, and 816. The lighting device disclosed in the embodiment applied to the lamp units 810, 812, 814, and 816 may emit light with a uniform distribution.

The first and second lamp units 810 and 812 may be provided in at least one of a curved shape, a straight shape, an angular shape, an inclined shape, or a planar shape, or a mixed structure thereof. The first and second lamp units 810 and 812 may be disposed one or more in each tail light. The first lamp unit 810 may be provided as a tail light, the second lamp unit 812 may be provided as a brake light, the third lamp unit 814 may be provided as a reverse light, and the fourth lamp unit 816 may be provided as a turn signal lamp. The structure and position of these lighting lamps may be changed.

Features, structures, effects, and the like described in the embodiments are included in at least one embodiment of the invention, and are not necessarily limited to only one embodiment. Furthermore, the features, structures, effects, and the like illustrated in each embodiment may be combined or modified for other embodiments by a person having ordinary knowledge in the field to which the embodiments belong. Accordingly, contents related to such combinations and modifications should be construed as being included in the scope of the invention. In addition, although the examples have been described above, these are only examples and do not limit the invention, and those of ordinary skill in the field to which the invention pertains are illustrated above within the scope not departing from the essential characteristics of the present embodiment. It will be seen that various modifications and applications that have not been made are possible. For example, each component specifically shown in the embodiment may be modified and implemented. And differences related to these modifications and applications should be construed as being included in the scope of the invention defined in the appended claims.

## Claims

1. A lighting device comprising:
a substrate;
a light source disposed on the substrate;
a resin layer sealing the light source;
a reflective layer disposed between the substrate and the resin layer;
a reflective portion bent from the reflective layer to face an emission surface of the light source; and
a bonding portion disposed between the reflective portion and the substrate.

2. A lighting device comprising:
a substrate;
a light source disposed on the substrate;
a resin layer sealing the light source;
a first reflective layer disposed between the substrate and the resin layer;
an upper reflective layer disposed on the resin layer and facing the reflective layer;
a reflective portion bent from the reflective layer to face a side surface excluding an emission surface of the light source; and
a bonding portion disposed between the reflective portion and the substrate.

3. The lighting device of claim 1 or 2, wherein the substrate includes a bonding pad to which the bonding portion is bonded.

4. The lighting device of claim 3, wherein an upper end of the reflective portion is disposed higher than an upper surface of the light source.

5. The lighting device of claim 3, wherein the bonding portion has a continuous or discontinuous loop shape.

6. The lighting device of claim 1, wherein the reflective portion is bent toward an upper surface of the resin layer in a region adjacent to a first surface of the resin layer facing the emission surface of the light source.

7. The lighting device of claim 6, wherein a lower line of the reflective portion is a straight line or a curved shape along a side surface of the resin layer.

8. The lighting device of claim 1, wherein the bonding portion is disposed in a circular or polygonal shape around the light source.

9. The lighting device of claim 3, wherein an end of the reflective portion is exposed to a side surface of the resin layer.

10. The lighting device of claim 1 or 2, wherein the reflective portion extends from the reflective layer with a thickness equal to a thickness of the reflective layer.
